# EUROPÄISCHE PATENTSCHRIFT

(11) **EP 1 880 449 B1**
(45) Veröffentlichungstag und Bekanntmachung des Hinweises auf die Patenterteilung: **06.09.2017**
(21) Anmeldenummer: 06742279.0
(22) Anmeldetag: 27.04.2006
(51) Int. Cl.: H01R 33/945, H05B 41/02, H05B 41/04, H05K 1/02

(54) **LAMPENSOCKEL UND HOCHDRUCKENTLADUNGSLAMPE MIT EINEM LAMPENSOCKEL**
LAMP BASE AND HIGH-PRESSURE DISCHARGE LAMP WITH A LAMP BASE
CULOT DE LAMPE ET LAMPE A DECHARGE HAUTE PRESSION MUNIE D'UN CULOT

(30) Priorität: 09.05.2005 DE 102005021728
(43) Veröffentlichungstag der Anmeldung: 23.01.2008
(73) Patentinhaber: OSRAM GmbH, 80807 München (DE)
(72) Erfinder: HACKENBUCHNER, Stefan, 80687 München (DE); HIRSCHMANN, Günther, 81735 München (DE)
(86) Internationale Anmeldenummer: PCT/DE2006/000736
(87) Internationale Veröffentlichungsnummer: WO 2006/119726

(56) Entgegenhaltungen:
- WO-A-2005/022576
- US-A1- 2004 066 150
- US-B1- 6 345 997

## Beschreibung

Die Erfindung betrifft einen Lampensockel gemäß dem Oberbegriff des Patentanspruchs 1 und eine Hochdruckentladungslampe mit einem derartigen Lampensockel.

### I. Stand der Technik

Ein derartiger Lampensockel ist beispielsweise in der Offenlegungsschrift WO 2005/022576 offenbart. Diese Schrift beschreibt eine Hochdruckentladungslampe für einen Kraftfahrzeugscheinwerfer mit einer im Lampensockel angeordneten Zündvorrichtung, deren Bauteile auf einer Leiterplatte montiert sind. Die vom sockelfernen Ende des Entladungsgefäßes zum Sockel zurückgeführte Stromzuführung ist mit einem elektrischen Kontakt des Leiterplatte verbunden.

Die US 2004/0066150 A1 offenbart einen Lampensockel für eine Hochdruckentladungslampe mit einer im Lampensockel integrierten Zündvorrichtung.

Es hat sich gezeigt, dass während der Zündphase der Hochdruckentladungslampe an der vorgenannte Stromzuführung, die üblicherweise auf Massebezugspotential liegt, hohe Spannungen auftreten können, die zu elektrischen Überschlägen zwischen dieser Stromzuführung und den Leiterbahnen auf der Leiterplatte führen. Die vorgenannten hohe Spannungen werden während der Zündphase der Hochdruckentladungslampe durch Funkentstördrosseln verursacht, die mit der Stromzuführung verbunden sind.

### II. Darstellung der Erfindung

Es ist Aufgabe der Erfindung, einen gattungsgemäßen Lampensockel und eine Hochdruckentladungslampe mit einer verbesserten Isolierung zwischen der auf der Leiterplatte verlaufenden Leiterbahnen und der mit einem elektrischen Kontakt auf der Leiterplatte verbundenen Stromzuführung der Lampe bereitzustellen.

Diese Aufgabe wird erfindungsgemäß durch die Merkmale des Patentanspruchs 1 gelöst. Besonders vorteilhafte Ausführungen der Erfindung sind in den abhängigen Patentansprüchen beschrieben.

Der erfindungsgemäße Lampensockel besitzt eine in seinem Innenraum angeordneten Leiterplatte, die mit elektrischen Bauteilen bestückt und mit Leiterbahnen zur elektrischen Kontaktierung der Bauteile versehen ist, wobei mindestens ein elektrischen Kontakt für eine Stromzuführung der Hochdruckentladungslampe auf der Leiterplatte angeordnet ist. Mindestens eine Trennwand ist zur elektrischen Isolierung zwischen dem mindestens einen elektrischen Kontakt bzw. der Stromzuführung und den Leiterbahnen der Leiterplatte vorgesehen. Dadurch werden, insbesondere während der Zündphase der Hochdruckentladungslampe, elektrische Überschläge zwischen der Stromzuführung und den Leiterbahnen auf der Leiterplatte vermieden.

Vorteilhafterweise ragt die mindestens eine Trennwand zu dem vorgenannten Zweck aus der Ebene der Leiterplatte heraus und ist zwischen dem elektrischen Kontakt der mindestens einen Stromzuführung und einer oder mehrerer dazu benachbarten Leiterbahnen angeordnet. Vorzugsweise umschließt die mindestens eine Trennwand den elektrischen Kontakt auf der Leiterplatte zumindest teilweise, um elektrische Überschläge zwischen der mindestens einen Stromzuführung und den zum elektrischen Kontakt benachbarten Leiterbahnen zu vermeiden. Die Höhe der mindestens einen Trennwand über der Leiterplatte beträgt vorzugsweise mindestens 5 Millimeter, um eine Durchschlagsfestigkeit von 10000 Volt zu gewährleisten.

Die mindestens eine Trennwand ist vorteilhafterweise an eine Wand des Lampensockels angeformt und ragt durch einen Schlitz in der Leiterplatte hindurch. Dadurch werden Herstellung und Montage der Leiterplatte vereinfacht. Gemäß dem bevorzugten Ausführungsbeispiel der Erfindung ist die mindestens eine Trennwand an einen Deckel des Lampensockels angeformt und ragt durch einen Schlitz in der Leiterplatte hindurch. Dadurch wird die mindestens eine Trennwand erst nach der Montage der mit den elektrischen Bauteilen bestückten Leiterplatte im Lampensockel, beim Verschließen des Lampensockels mittels des Deckels montiert, so dass sie keine Behinderung während dem Bestücken der Leiterplatte mit den elektrischen Bauteilen und während der Montage der Leiterplatte im Lampensockel verursacht.

Die Leiterplatte ist vorzugsweise als Leadframe ausgebildet, um den hohen Betriebstemperaturen im Lampensockel standzuhalten.

### III. Beschreibung des bevorzugten Ausführunesbeispiels

Nachstehend wird die Erfindung anhand eines bevorzugten Ausführungsbeispiels näher erläutert. Es zeigen:
- Figur 1: Eine Seitenansicht einer Hochdruckentladungslampe mit einem Lampensockel gemäß dem bevorzugten Ausführungsbeispiel der Erfindung
- Figur 2: Eine Draufsicht auf die Vorderseite des im Lampensockel angeordneten Leadframes mit seinen Leiterbahnen, aber ohne elektrische Bauteile
- Figur 3: Eine Draufsicht auf die Rückseite des in Figur 2 abgebildeten Leadframes
- Figur 4: Eine Draufsicht auf das Leadframe und den Deckel des Lampensockels zur Illustration des Ineinandergreifens der am Deckel angeformten Trennwände und der im Leadframe angeordneten Schlitze
- Figur 5: Eine Draufsicht auf den Deckel aus Figur 4 mit den angeformten Trennwänden

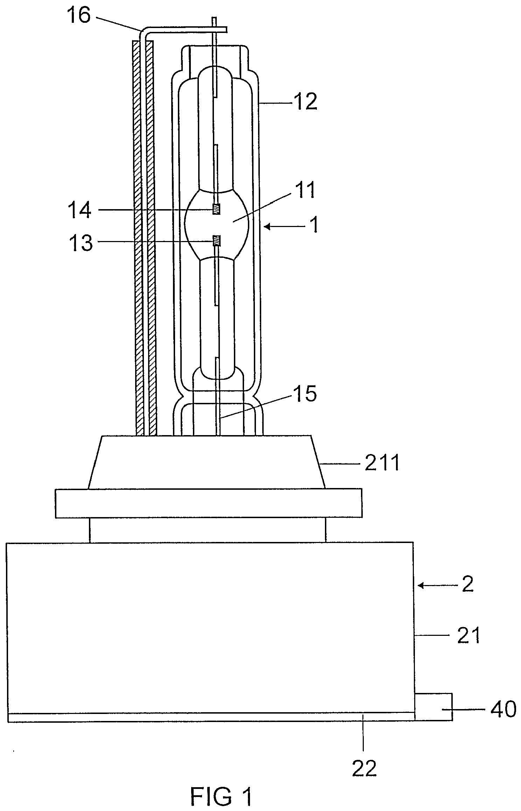

In Figur 1 ist eine Hochdruckentladungslampe mit einem Lampensockel gemäß dem bevorzugten Ausführungsbeispiel der Erfindung abgebildet. Bei dieser Hochdruckentladungslampe handelt es sich um eine Halogen-Metalldampf-Hochdruckentladungslampe mit einer im Lampensockel integrierten Impulszündvorrichtung. Diese Hochdruckentladungslampe ist zur Verwendung als Lichtquelle in einem Kraftfahrzeugscheinwerfer vorgesehen.

Die Hochdruckentladungslampe besitzt ein von einem gläsernen Außenkolben 12 umschlossenes Entladungsgefäß 11 aus Quarzglas mit darin angeordneten Elektroden 13, 14 zum Erzeugen einer Gasentladung. Die Elektroden 13, 14 sind jeweils mit einer aus dem Entladungsgefäß 11 herausgeführten Stromzuführung 15 bzw. 16 verbunden, über die sie mit elektrischer Energie versorgt werden. Die aus dem Entladungsgefaß 11 und dem Außenkolben 12 bestehenden Baueinheit 1 ist im Lampensockel 2 fixiert. Der Lampensockel 2 umfasst ein Gehäuseteil 21 und einen Deckel 22, der die Kammern des Gehäuseteils 21 verschließt, sowie eine Steckerbuchse 40 zur Spannungsversorgung der Hochdruckentladungslampe.

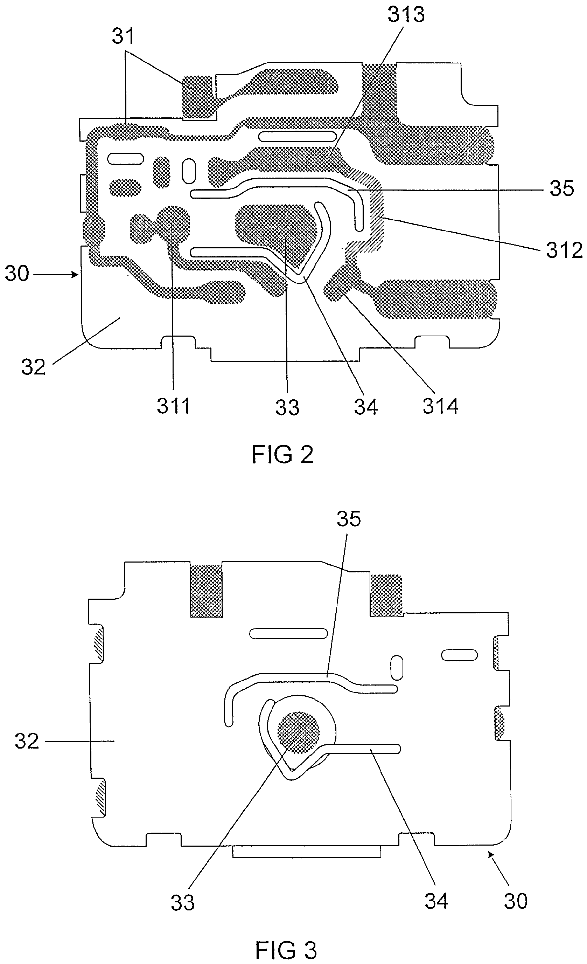

Innerhalb des Gehäuseteils 21 ist eine als Impulszündvorrichtung ausgebildete Zündvorrichtung zum Zünden der Gasentladung in der Hochdruckentladungslampe angeordnet. Die Impulszündvorrichtung umfasst einen Zündtransformator, eine Funkenstrecke und einen Zündkondensator. Während der Zündphase der Hochdruckentladungslampe wird der Zündkondensator auf die Durchbruchsspannung der Funkenstrecke aufgeladen. Beim elektrischen Durchbruch der Funkenstrecke entlädt sich der Zündkondensator über die Primärwicklung des Zündtransformators, so dass an seiner Sekundärwicklung die zum Zünden der Gasentladung in der Hochdruckentladungslampe erforderlichen Hochspannungsimpulsen induziert werden. Die elektrischen der Bauteile dieser Zündvorrichtung und zusätzlich auch eine oder zwei Funkentstördrosseln sind auf einer als Leadframe ausgebildeten Leiterplatte 30 montiert. Das Leadframe 30 besteht aus einer Vielzahl von Metallstegen 31, die in elektrisch isolierendem Kunststoffmaterial 32 mittels Spritzgusstechnik eingebettet sind. Die Metallstege 31 bilden Leiterbahnen für die auf dem Leadframe 30 montierten Bauteile (nicht abgebildet) aus. Figur 2 zeigt die Vorderseite bzw. Montagefläche des Leadframes 30 mit den an der Oberseite verlaufenden Leiterbahnen 31 und dem elektrischen Kontakt 33, der zur Kontaktierung der Stromrückführung 16 auf dem Leadframe 30 dient. In Figur 3 ist die Rückseite des Leadframes 30 abgebildet, die dem Deckel 22 des Lampensockels 2 zugewandt ist.

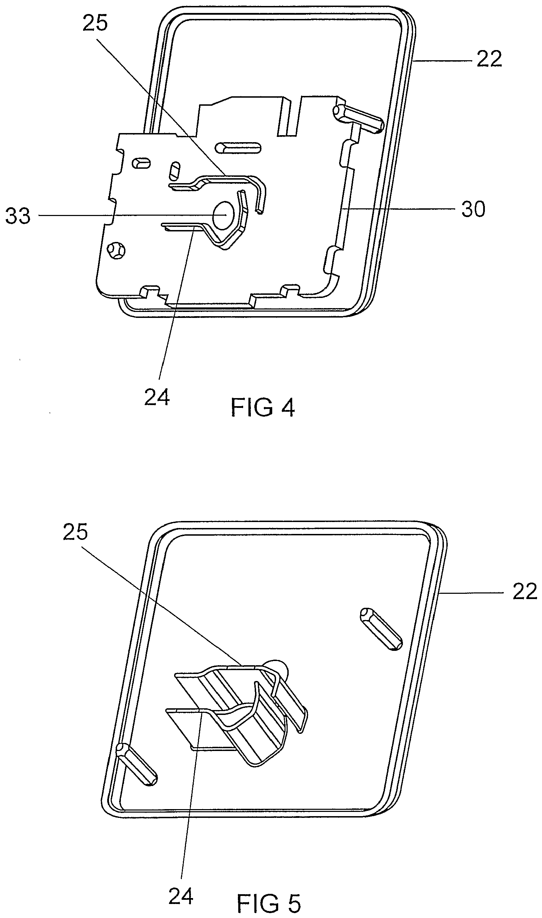

Das Leadframe 30 weist zwei Durchbrüche bzw. Schlitze 34, 35 in dem Kunststoffmaterial 32 auf, die den elektrischen Kontakt 33 von drei Seiten umschließen. Durch diese Schlitze 34, 35 ragen zwei Trennwände 24, 25 hindurch, die an die Innenseite des Deckels 22 angeformt sind. Nach der Montage des mit den elektrischen Bauteilen der Zündvorrichtung bestückten Leadframes 30 im Gehäuseteil 21 und dem Aufstecken des Deckels 22 ragen die Trennwände 24, 25 durch die Schlitze in dem Leadframe 30 hindurch, so dass die Trennwände 24, 25 über der von dem Deckel 22 abgewandten Vorderseite bzw. Montagefläche des Leadframes 30 eine Höhe von 6 Millimeter besitzen. Figur 5 zeigt die Innenseite des aus Kunststoff bestehenden Deckels 22 mit den angeformten Trennwänden 24, 25, die ebenfalls aus Kunststoff bestehen. In Figur 4 sind das Leadframe 30 (ohne Leiterbahnen) und die Innenseite des Deckels 22 mit den angeformten Trennwänden 24, 25 abgebildet. Der Deckel 22 und die Trennwände 24, 25 sind als Spritzgussteil ausgebildet. Die Trennwände 24, 25 bilden eine an einer Seite offene Kammer. Die Öffnung dieser Kammer ist so gewählt, dass ausreichend Platz für eine Funkentstördrossel auf dem Leadframe 30 bleibt, die mit dem elektrischen Kontakt 33 und der benachbarten Leiterbahn 311 verbunden ist.

Um ausreichend Platz auf dem Leadframe 30 für alle Bauteile der Zündvorrichtung zu schaffen, sind die Leiterbahnen 31 auf der Vorder- und Rückseite des Leadframes 30 angeordnet. In Figur 2 ist schematisch ein als Tiefziehteil ausgebildeter Metallsteg 312 dargestellt, der die beiden Leiterbahnen 313, 314 miteinander verbindet und vollständig in dem Kunststoffmaterial 32 des Leadframes 30 eingebettet ist. Daher ist er in der Figur 2 mit einer anderen Schraffur versehen als die anderen Leiterbahnen, weil er durch das Kunststoffmaterial 32 bedeckt und auf der Vorderseite normalerweise nicht sichtbar ist. Dadurch wird ausreichend Platz auf der Vorderseite des Leadframes 30 für die Montage des Zündkondensators der Impulszündvorrichtung geschaffen.

## Patentansprüche

1. Lampensockel für eine Hochdruckentladungslampe mit einer im Innenraum des Lampensockels (2) angeordneten Leiterplatte (30), die mit elektrischen Bauteilen bestückt ist und mit Leiterbahnen (31) zur elektrischen Kontaktierung der Bauteile versehen ist, wobei auf der Leiterplatte (30) mindestens ein elektrischer Kontakt (33) für eine Stromzuführung (16) der Hochdruckentladungslampe angeordnet ist, wobei mindestens eine Trennwand (24, 25) zur elektrischen Isolierung zwischen dem mindestens einen elektrischen Kontakt (33) bzw. der Stromzuführung (16) und den Leiterbahnen (31) der Leiterplatte (30) vorgesehen ist, **dadurch gekennzeichnet, dass** die mindestens eine Trennwand (24, 25) eine an einer Seite offene Kammer bildet.

2. Lampensockel nach Anspruch 1, **dadurch gekennzeichnet, dass** die mindestens eine Trennwand (24, 25) aus der Ebene der Leiterplatte (30) herausragt und zwischen dem elektrischen Kontakt (33) der mindestens einen Stromzuführung (16) und einer oder mehreren dazu benachbarten Leiterbahnen angeordnet ist.

3. Lampensockel nach Anspruch 1 oder 2, **dadurch gekennzeichnet, dass** die mindestens eine Trennwand (24, 25) den elektrischen Kontakt (33) der mindestens einen Stromzuführung (16) zumindest teilweise umschließt.

4. Lampensockel nach einem oder mehreren der Ansprüche 1 bis 3, **dadurch gekennzeichnet, dass** die Höhe der mindestens einen Trennwand (24, 25) über der Leiterplatte (30) mindestens 5 Millimeter beträgt.

5. Lampensockel nach einem oder mehreren der Ansprüche 1 bis 4, **dadurch gekennzeichnet, dass** die mindestens eine Trennwand (24, 25) an eine Wand des Lampensockels (2) angeformt ist und durch einen Schlitz (34, 35) in der Leiterplatte (30) hindurchragt.

6. Lampensockel nach einem oder mehreren der Ansprüche 1 bis 4, **dadurch gekennzeichnet, dass** die mindestens eine Trennwand (24, 25) an einen Deckel (22) des Lampensockels (2) angeformt ist und durch einen Schlitz (34, 35) in der Leiterplatte (30) hindurchragt.

7. Hochdruckentladungslampe mit einem Lampensockel nach einem oder mehreren der Ansprüche 1 bis 6.

## Claims

1. Lamp base for a high-pressure discharge lamp with a printed circuit board (30), which is arranged in the interior of the lamp base (2), is populated with electrical component parts and is provided with conductor tracks (31) for making electrical contact with the component parts, at least one electrical contact (33) for a power supply line (16) of the high-pressure discharge lamp being arranged on the printed circuit board (30), wherein at least one partition (24, 25) is provided for electrical insulation purposes between the at least one electrical contact (33) or the power supply line (16) and the conductor tracks (31) of the printed circuit board (30), **characterized in that** the at least one partition (24, 25) forms a chamber which is open on one side.

2. Lamp base according to Claim 1, **characterized in that** the at least one partition (24, 25) protrudes out of the plane of the printed circuit board (30) and is arranged between the electrical contact (33) of the at least one power supply line (16) and one or more conductor tracks adjacent thereto.

3. Lamp base according to Claim 1 or 2, **characterized in that** the at least one partition (24, 25) at least partially surrounds the electrical contact (33) of the at least one power supply line (16).

4. Lamp base according to one or more of Claims 1 to 3, **characterized in that** the height of the at least one partition (24, 25) above the printed circuit board (30) is at least 5 millimeters.

5. Lamp base according to one or more of Claims 1 to 4, **characterized in that** the at least one partition (24, 25) is integrally formed on a wall of the lamp base (2) and protrudes through a slot (34, 35) in the printed circuit board (30).

6. Lamp base according to one or more of Claims 1 to 4, **characterized in that** the at least one partition (24, 25) is integrally formed on a cover (22) of the lamp base (2) and protrudes through a slot (34, 35) in the printed circuit board (30).

7. High-pressure discharge lamp with a lamp base according to one or more of Claims 1 to 6.

## Revendications

1. Culot de lampe pour une lampe à décharge à haute pression comprenant une plaquette à circuit imprimé (30) disposée dans l'espace intérieur du culot de lampe (2), laquelle plaquette à circuit imprimé est équipée de composants électriques et ménagée avec des pistes conductrices (31) pour la mise en contact électrique des composants, au moins un contact électrique (33) étant disposé sur la plaquette à circuit imprimé (30) pour une alimentation en courant (16) de la lampe à décharge à haute pression, au moins une paroi de séparation (24, 25) destinée à l'isolation électrique entre l'au moins un contact électrique (33) resp. l'alimentation en courant (16) et les pistes conductrices (31) de la plaquette à circuit imprimé (30) étant ménagée, **caractérisé en ce que** l'au moins une paroi de séparation (24, 25) forme une chambre ouverte sur un côté.

2. Culot de lampe selon la revendication 1, **caractérisé en ce que** l'au moins une paroi de séparation (24, 25) fait saillie du plan de la plaquette à circuit imprimé (30) et est disposée entre le contact électrique (33) de l'au moins une alimentation en courant (16) et une ou plusieurs pistes conductrices qui y sont adjacentes.

3. Culot de lampe selon la revendication 1 ou 2, **caractérisé en ce que** l'au moins une paroi de séparation (24, 25) entoure au moins en partie le contact électrique (33) de l'au moins une alimentation en courant (16).

4. Culot de lampe selon l'une quelconque des revendications 1 à 3, **caractérisé en ce que** la hauteur de l'au moins une paroi de séparation (24, 25) au-delà de la plaquette à circuit imprimé (30) est d'au moins 5 millimètres.

5. Culot de lampe selon l'une quelconque des revendications 1 à 4, **caractérisé en ce que** l'au moins une paroi de séparation (24, 25) est formée sur une paroi du culot de lampe (2) et traverse une fente (34, 35) dans la plaquette à circuit imprimé (30).

6. Culot de lampe selon l'une quelconque des revendications 1 à 4, **caractérisé en ce que** l'au moins une paroi de séparation (24, 25) est formée sur un couvercle (22) du culot de lampe (2) et traverse une fente (34, 35) dans la plaquette à circuit imprimé (30).

7. Lampe à décharge à haute pression comprenant un culot de lampe selon une quelconque ou plusieurs des revendications 1 à 6.
